(19) **Europäisches Patentamt**

**European Patent Office**

**Office européen des brevets**

(11) **EP 1 369 813 B1**

(12) **FASCICULE DE BREVET EUROPEEN**

(45) Date de publication et mention
de la délivrance du brevet:
**22.02.2006 Bulletin 2006/08**

(51) Int Cl.:
*G06K 7/00* (2006.01)     *H03D 5/00* (2006.01)

(21) Numéro de dépôt: **03354053.5**

(22) Date de dépôt: **04.06.2003**

(54) **Lecteur de transpondeur électromagnétique**

Lesegerät für einen elektromagnetischen Transponder

Reader for electromagnetic transponder

(84) Etats contractants désignés:
**DE FR GB IT**

(30) Priorité: **06.06.2002 FR 0207000**

(43) Date de publication de la demande:
**10.12.2003 Bulletin 2003/50**

(73) Titulaire: **STMicroelectronics S.A.**
**92120 Montrouge (FR)**

(72) Inventeur: **Enguent, Jean-Pierre**
**13119 Saint Savournin (FR)**

(74) Mandataire: **de Beaumont, Michel**
**Cabinet Michel de Beaumont**
**1, rue Champollion**
**38000 Grenoble (FR)**

(56) Documents cités:
**EP-A- 0 892 493**     **EP-A- 1 043 679**
**US-A- 6 028 503**

## Description

La présente invention concerne des systèmes utilisant des transpondeurs électromagnétiques, c'est-à-dire des émetteurs-récepteurs (généralement mobiles) susceptibles d'être interrogés, sans contact et sans fil, par une unité (généralement fixe) dite borne de lecture et/ou d'écriture. L'invention concerne, plus particulièrement, une borne de lecture ou de lecture-écriture de transpondeurs qui sont dépourvus d'alimentation autonome. Ces transpondeurs extraient l'alimentation nécessaire aux circuits électroniques qu'ils comportent du champ haute fréquence rayonné par une antenne de la borne de lecture et d'écriture. L'invention s'applique à de telles bornes, qu'il s'agisse de bornes se contentant de lire les données du transpondeur (par exemple, une étiquette électronique) ou de bornes de lecture-écriture qui sont susceptibles de modifier des données du transpondeur (par exemple, une carte à puce sans contact).

Les systèmes utilisant des transpondeurs électromagnétiques sont basés sur l'emploi de circuits oscillants comprenant un enroulement formant antenne, côté transpondeur et côté borne de lecture-écriture. Ces circuits sont destinés à être couplés par champ magnétique proche lorsque le transpondeur entre dans le champ de la borne de lecture-écriture.

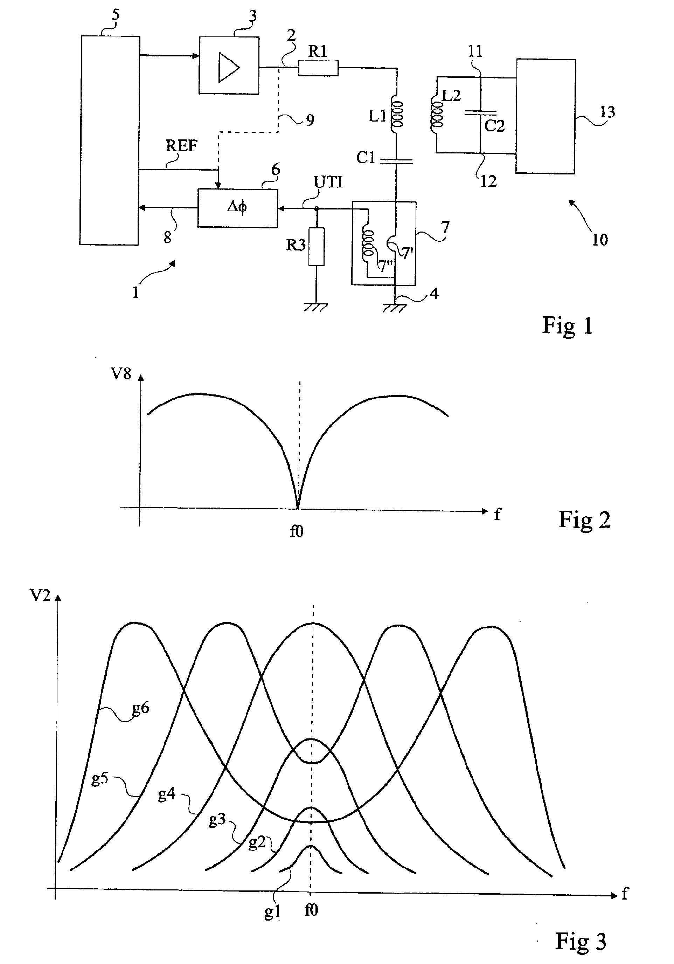

La figure 1 représente, de façon très schématique et simplifiée, un exemple classique de système d'échanges de données entre une borne 1 de lecture-écriture et un transpondeur 10.

Généralement, la borne 1 est essentiellement constituée d'un circuit oscillant série, formé d'une inductance L1, en série avec un condensateur C1 et une résistance R1, entre une borne 2 de sortie d'un amplificateur ou coupleur d'antenne 3 et une borne 4 de référence (généralement, la masse). Le coupleur d'antenne 3 reçoit un signal de transmission haute fréquence généré par un modulateur (non représenté) faisant partie d'un circuit 5 de commande et d'exploitation des données, et comprenant, entre autres, un modulateur-démodulateur et un microprocesseur de traitement des commandes et des données. Le circuit 5 comprend également un oscillateur à quartz permettant de fournir un signal de référence haute fréquence. Ce signal de référence est, dans certains cas, utilisé en guise de signal REF de référence d'un démodulateur de phase 6 ($\Delta\phi$) dont le rôle est de démoduler une éventuelle transmission de données issue du transpondeur 10. Le cas échéant, le signal REF n'est pas extrait du circuit 5 c'est-à-dire directement de l'oscillateur à quartz mais est prélevé sur la borne 2 de sortie du coupleur d'antenne 3 (pointillés 9, figure 1).

Le transpondeur 10 comporte essentiellement un circuit oscillant parallèle formé d'une inductance L2, en parallèle avec un condensateur C2 entre deux bornes 11, 12 d'entrée d'un circuit 13 de commande et de traitement. Les bornes 11 et 12 sont, en pratique, reliées à l'entrée d'un moyen de redressement (non représenté) dont les sorties définissent les bornes d'alimentation continues des circuits internes au transpondeur. Ces circuits comprennent généralement, essentiellement, un microprocesseur, une mémoire, un démodulateur des signaux éventuellement reçus de la borne 1, et un modulateur pour transmettre des informations à la borne.

En l'absence de transmission de données de la borne vers le transpondeur, le signal d'excitation haute fréquence sert uniquement de source d'énergie.

La transmission éventuelle d'informations de la borne au transpondeur s'effectue, par exemple, en modulant l'amplitude de la porteuse de télé-alimentation.

La transmission d'informations du transpondeur 10 vers la borne 1 s'effectue généralement en modifiant la charge du circuit oscillant L2, C2 de sorte que le transpondeur prélève une quantité d'énergie plus ou moins importante du champ magnétique haute fréquence. Cette variation est détectée, côté borne 1, dans la mesure où l'amplitude du signal d'excitation haute fréquence est maintenue constante. Par conséquent, une variation d'énergie du transpondeur se traduit par une variation d'amplitude et de phase du courant dans l'antenne L1. Cette variation est alors détectée, par exemple, au moyen du démodulateur de phase 6 de la borne 1. Pour ce faire et par exemple, ce démodulateur 6 reçoit un signal utile UTI provenant d'une conversion courant-tension au moyen d'une résistance R3 entre une borne d'entrée du démodulateur 6 et la masse 4. La résistance R3 convertit, en tension, le courant mesuré dans le circuit oscillant R1, L1, C1 au moyen, par exemple, d'un transformateur d'intensité 7 connecté en série avec le circuit oscillant. Le transformateur d'intensité 7 a été symbolisé à la figure 1 par deux enroulements 7', 7". L'enroulement primaire 7' est en série avec le circuit oscillant. L'enroulement secondaire 7" est connecté par une première borne à la masse et par une deuxième borne à la borne d'entrée du démodulateur de phase 6.

Pour transmettre des données du transpondeur vers la borne, un étage de modulation (non représenté) du transpondeur est commandé à une fréquence (par exemple, 847,5 kHz) dite sous-porteuse nettement inférieure (généralement avec un rapport d'au moins 10) à la fréquence du signal d'excitation du circuit oscillant de la borne (par exemple, 13,56 MHz). La variation de charge côté transpondeur est généralement effectuée au moyen d'un interrupteur électronique de commande d'une résistance ou d'un condensateur modifiant la charge du circuit oscillant L2-C2. L'interrupteur électronique est commandé à la fréquence de la sous-porteuse pour soumettre, périodiquement, le circuit oscillant du transpondeur à un amortissement supplémentaire par rapport à la charge constituée par ses circuits d'exploitation 13.

Dans les demi-périodes de la sous-porteuse où l'interrupteur électronique du transpondeur est fermé, le démodulateur 6 détecte un léger déphasage (quelques degrés voire moins d'un degré) de la porteuse haute fréquence par rapport au signal de référence REF. La sortie 8 du démodulateur 6 restitue alors un signal image du signal de commande de l'interrupteur électronique du transpondeur, qui peut être décodé pour restituer les données binaires transmises.

Un problème auquel on se trouve confronté avec les bornes de lecture-écriture classiques utilisant un démodulateur de phase est que la réponse du démodulateur de phase en fréquence présente, quand les deux circuits oscillants sont accordés sur la fréquence de télé-alimentation (13,56 MHz), un zéro (c'est-à-dire que la tension de sortie s'annule) à une fréquence du signal à démoduler correspondant à cette fréquence de télé-alimentation.

Ce phénomène est illustré par la figure 2 qui représente, de façon schématique, la réponse d'un démodulateur de phase 6. La figure 2 représente l'allure de la tension V8 en sortie du démodulateur 6 en fonction de la fréquence de la porteuse sur laquelle est détecté le déphasage. Comme l'illustre cette figure, la tension s'annule pour une fréquence f0 qui correspond, pour un coefficient de couplage donné, à la fréquence de résonance du circuit oscillant L2-C2 du transpondeur ( $f = 1/2\pi\sqrt{LC}$ ).

Pour résoudre ce problème, on désaccorde généralement les circuits oscillants de façon à ce que les deux circuits oscillants de la borne et du transpondeur ne soient pas tous deux accordés sur la fréquence de la porteuse de télé-alimentation.

Toutefois, un inconvénient qui en découle est que cela nuit à la télé-alimentation du transpondeur, donc à la portée du système. En effet, l'énergie récupérée par le transpondeur est maximale lorsque les deux circuits oscillants de la borne et du transpondeur sont tous deux accordés sur la fréquence de la porteuse.

Un autre problème est que les tolérances de fabrication des condensateurs utilisés pour les circuits oscillants, en particulier pour le condensateur C2 du transpondeur, sont généralement de l'ordre de 10 %. Par conséquent, l'importance de ces tolérances de fabrication conduit à devoir, par sécurité, se décaler sensiblement de la fréquence f0 de la porteuse si on veut garantir une démodulation de phase par la borne.

Ainsi, un inconvénient notable des systèmes classiques est que l'on est contraint d'effectuer un compromis entre la télé-alimentation et la capacité de démodulation de phase par la borne.

De plus, ce compromis est délicat à réaliser dans la mesure où la position du "trou" dans la réponse du démodulateur de phase varie en fonction de la mutuelle inductance entre les circuits oscillants. Or, cette mutuelle inductance dépend de la distance qui sépare les antennes L1 et L2 de la borne et du transpondeur, donc de la position relative du transpondeur par rapport à la borne lors de la transmission.

Cette variation est illustrée par la figure 3 qui représente, pour plusieurs écarts entre un transpondeur et une borne, des exemples de caractéristiques tension-fréquence, où la tension représente la tension de télé-alimentation du transpondeur, par exemple, la tension V2 aux bornes du condensateur C2, et où f correspond à la fréquence d'excitation du circuit oscillant série de la borne.

Les différentes courbes illustrées à la figure 3 sont tracées pour des circuits oscillants accordés sur la fréquence f0, c'est-à-dire des circuits oscillants de la borne et du transpondeur qui sont tous deux dimensionnés pour présenter une fréquence de résonance correspondant à la porteuse de télé-alimentation. Les courbes g1, g2, g3, g4, g5 et g6 indiquent des distances décroissantes entre le transpondeur et la borne. En d'autres termes, la courbe g1 qui représente un petit dôme centré sur la fréquence f0 correspond sensiblement à la limite de portée du système. Plus la distance se réduit, plus le pic du dôme constitué par la caractéristique tension-fréquence augmente, comme l'illustrent les courbes g2, g3 et g4. La courbe g4 illustre la position de couplage optimal, c'est-à-dire la distance à laquelle le couplage est optimisé par une amplitude de télé-alimentation maximale reçue par le transpondeur à la fréquence f0. A partir de cette distance, si on rapproche encore le transpondeur de la borne 1, on constate que l'amplitude de la tension diminue (courbe g5) de plus en plus (courbe g6) au fur et à mesure que l'écart entre les inductances L1 et L2 diminue, la tension V2 présentant alors deux maximum pour des fréquences encadrant la fréquence f0. Il en découle qu'en décalant la fréquence de résonance sur laquelle sont dimensionnés les circuits oscillants par rapport à la fréquence de la porteuse, on déplace horizontalement l'axe vertical de fonctionnement du système dans la caractéristique de la figure 3 et, par conséquent, on diminue la tension de télé-alimentation récupérée, au moins pour les courbes g1 à g4.

Les problèmes combinés de trou de phase dans les démodulateurs de phase et de variation de la position de ce trou de phase par rapport à la distance entre les inductances, associés aux tolérances de fabrication des composants, rendent les systèmes classiques peu fiables.

Une première solution serait de remplacer le démodulateur de phase par un démodulateur d'amplitude. En effet, la variation de charge provoquée par le transpondeur sur le circuit oscillant de la borne se traduit également par une légère variation d'amplitude qui peut alors être détectée par une mesure, soit du courant dans le circuit oscillant de la borne, soit de la tension aux bornes du condensateur C1.

Toutefois, cette solution ne fait que transposer le problème dans la mesure où la réponse spectrale d'un démodulateur d'amplitude présente également un trou de démodulation, c'est-à-dire une fréquence pour laquelle la tension récupérée en sortie du démodulateur est nulle. La variation importante des fréquences de résonance des circuits oscillants due aux tolérances de fabrication des condensateurs, associée à la variation importante de la position du trou de démodulation en fonction du couplage entre les circuits oscillants font que, en pratique, l'utilisation d'un démodulateur d'amplitude risque de poser sensiblement les mêmes problèmes que l'utilisation d'un démodulateur de phase.

Le document WO-A-96 18969 décrit un système d'émission-réception sans contact dans lequel le lecteur utilise à la fois un démodulateur de phase et un démodulateur d'amplitude, et sélectionne le signal de sortie de meilleur niveau.

Toutefois, la solution décrite par ce document n'est pas pleinement satisfaisante. En effet, elle ne permet pas, en pratique, de modifier le choix entre la démodulation de phase et la démodulation d'amplitude, en cours de réception, les signaux démodulés par les deux démodulateurs n'étant pas forcément synchrones.

De plus, les inconvénients liés aux tolérances de fabrications des circuits oscillants et de leur dérive en fonctionnement subsistent.

Le document US 6028503 décrit un circuit de démodulation qui comprend un démodulateur de phase et un démodulateur d'amplitude. Dépendant de la phase du signal reçu, le circuit de démodulation décide si le signal est démodulé en phase ou en amplitude.

La présente invention vise à proposer une nouvelle solution pour résoudre les problèmes de réponse d'un démodulateur de phase et d'un démodulateur d'amplitude chargés de restituer des données émises par un transpondeur.

L'invention vise, plus particulièrement, à proposer une solution qui soit mise en oeuvre par la borne de lecture-écriture et qui ne nécessite aucune modification du transpondeur. En particulier, l'invention vise à proposer une solution qui puisse fonctionner avec des transpondeurs existants.

La présente invention vise également à proposer une nouvelle borne de lecture-écriture de transpondeur électromagnétique dans laquelle la réponse d'un démodulateur, à des données transmises par un transpondeur, est optimisée et rendue sensiblement indépendante de la fréquence de résonance des circuits oscillants et de la fréquence de la porteuse.

L'invention vise également à proposer une solution qui soit insensible aux éventuelles dérives de fonctionnement des circuit résonnants des transpondeurs.

L'invention vise également à proposer une solution qui s'affranchisse des éventuelles dispersions de fabrication des circuits oscillants de la borne et/ou des transpondeurs.

L'invention vise en outre à proposer une solution qui optimise la portée du système de transmission.

Pour atteindre ces objets et d'autres, la présente invention prévoit un circuit de démodulation d'un signal émis par un transpondeur électromagnétique, comprenant un capteur d'une grandeur fonction de la charge constituée par le transpondeur sur un circuit oscillant, un démodulateur de phase et un démodulateur d'amplitude au moins fonctionnellement en parallèle et recevant un signal issu dudit capteur, un sommateur des résultats fournis par lesdits démodulateurs, et un retardateur en série avec un premier desdits démodulateurs, pour compenser une éventuelle différence de temps de propagation entre eux.

Selon un mode de réalisation de la présente invention, le circuit comporte en outre un régulateur du retard apporté par ledit retardateur en fonction du signal fourni par ledit sommateur.

Selon un mode de réalisation de la présente invention, ledit premier démodulateur auquel est associé le retardateur est le démodulateur d'amplitude.

Selon un mode de réalisation de la présente invention, ledit régulateur comporte :

un élément de redressement dont l'entrée est reliée à la sortie du sommateur ;

un comparateur dont une première entrée reçoit le signal fourni par ledit élément de redressement et dont une deuxième entrée reçoit un signal de consigne, la sortie du comparateur commandant ledit élément retardateur.

Selon un mode de réalisation de la présente invention, ledit retardateur est constituée d'un élément résistif commandable en série avec ledit premier démodulateur, et d'un élément capacitif reliant une borne de l'élément résistif à un potentiel de référence.

Selon un mode de réalisation de la présente invention, ledit élément résistif est constitué d'un transistor à effet de champ dont une grille reçoit un signal de régulation fourni par ledit régulateur et qui conditionne sa résistance série.

Selon un mode de réalisation de la présente invention, lesdits démodulateurs, sommateur, retardateur et régulateur sont réalisés sous la forme d'un processeur numérique de traitement de signal.

Selon un mode de réalisation de la présente invention, ledit capteur mesure le courant dans le circuit oscillant, ou la tension aux bornes d'un ou plusieurs de ses éléments.

La présente invention prévoit également un borne de génération d'un champ électromagnétique propre à communiquer avec au moins un transpondeur lorsque ce dernier entre dans ce champ.

La présente invention prévoit en outre un procédé de démodulation d'un signal émis par un transpondeur électromagnétique consistant :

à mesurer une grandeur fonction de la charge constituée par le transpondeur sur un circuit oscillant ;
à démoduler en phase le signal mesuré ;
à démoduler en amplitude le signal mesuré ;
à retarder un premier résultat d'au moins une des démodulations par rapport à l'autre ;
à sommer les résultats des deux démodulations ; et
à réguler le retard apporté audit premier résultat de démodulation en fonction du résultat de la sommation.

Selon un mode de réalisation de la présente invention, le procédé est mis en oeuvre par des moyens de traitement numérique.

Selon un mode de réalisation de la présente invention, le procédé est mis en oeuvre par des circuits analogiques.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :

les figures 1 à 3 qui ont été décrites précédemment sont destinées à exposer l'état de la technique et le problème posé ;

la figure 4 représente, de façon très schématique et simplifiée, un mode de réalisation d'une borne de lecture-écriture selon la présente invention, associée à un transpondeur électromagnétique ;

la figure 5 illustre la caractéristique tension-fréquence d'un démodulateur d'amplitude ;

la figure 6 illustre la caractéristique tension-fréquence du circuit de démodulation de l'invention ; et

la figure 7 représente, sous forme de blocs, un mode de réalisation plus détaillé d'un circuit de démodulation selon la présente invention.

Les mêmes éléments ont été désignés par les mêmes références aux différentes figures. Pour des raisons de clarté, les figures 2, 3, 5 et 6 ne sont pas à l'échelle. Toujours pour des raisons de clarté, seuls les éléments qui sont nécessaires à la compréhension de l'invention ont été représentés aux figures et seront décrits par la suite. En particulier, les circuits de commande, de traitement et d'exploitation de la borne et du transpondeur n'ont pas été détaillés et ne font pas l'objet de la présente invention.

Une caractéristique de la présente invention est de prévoir, au sein d'une borne lecture-écriture de transpondeur électromagnétique, un circuit de démodulation qui, pour extraire une image du signal de modulation du transpondeur à partir d'une mesure du signal dans le circuit oscillant de la borne, somme les résultats d'une démodulation d'amplitude et d'une démodulation de phase en retardant l'un des deux résultats par rapport à l'autre. Le retard permet de résoudre les problèmes de synchronisation des deux résultats de démodulation. On peut alors utiliser leur somme, ce qui est considérablement plus simple qu'une sélection d'un des deux résultats. De plus, on compense la différence entre les délais de propagation des deux démodulations et on s'affranchit des problèmes liés aux tolérances de fabrication des composants des circuits oscillants.

Selon un mode de réalisation préféré de l'invention, le retard apporté à l'un des résultats de démodulation est asservi en fonction du signal fourni en sortie du circuit de démodulation. Un tel asservissement permet de compenser d'éventuelles dérives de la fréquence de résonance du circuit oscillant de la borne. On optimise ainsi la portée du système.

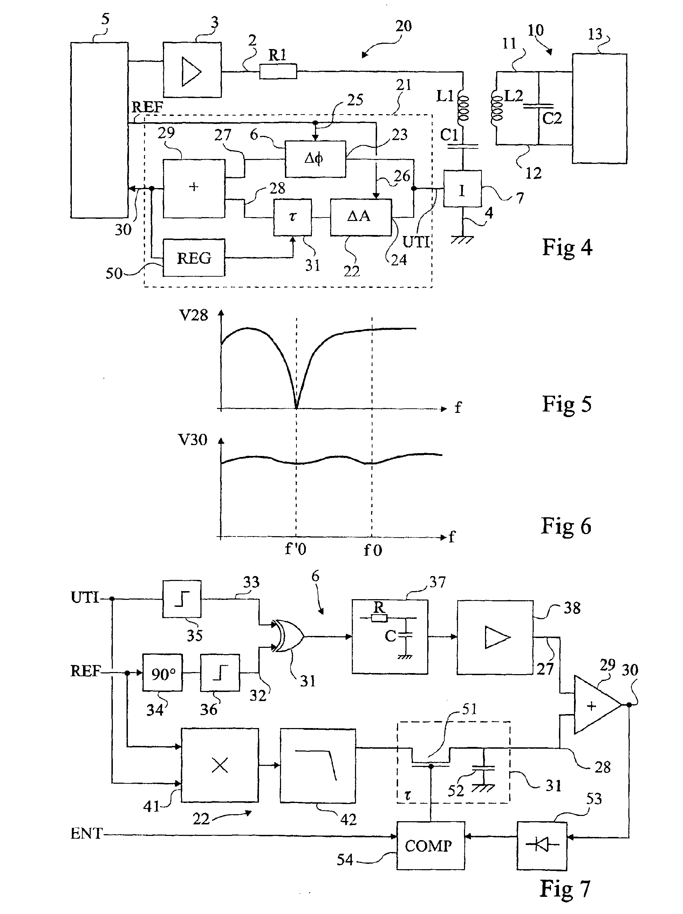

La figure 4 représente, de façon schématique et simplifiée, un mode de réalisation d'une borne de lecture-écriture 20 selon l'invention. A la figure 4, la borne 20 a été représentée associée à un transpondeur 10 classique.

Comme précédemment, le transpondeur 10 est essentiellement constitué d'un circuit oscillant parallèle, formé d'une inductance L2 en parallèle avec un condensateur C2 entre deux bornes 11, 12 d'un circuit 13 d'exploitation et de traitement.

Toujours comme précédemment, la borne 20 est basée sur un circuit oscillant série formé d'une résistance R1, d'une inductance L1 et d'un condensateur C1. Ce circuit oscillant est connecté en série avec un transformateur d'intensité 7 entre une borne 2 de sortie d'un amplificateur ou coupleur d'antenne 3 et la masse 4. La borne 20 est commandée et exploitée par un circuit 5 regroupant, essentiellement, un microprocesseur, un oscillateur à quartz, un modulateur et des moyens d'alimentation. Le transformateur d'intensité 7, ou tout autre moyen analogue de mesure de la tension ou du courant dans le circuit oscillant série, fournit un signal UTI en entrée d'un circuit 21 de démodulation. Ce circuit de démodulation reçoit, comme un circuit classique (figure 1), un signal de référence REF (provenant du circuit 5 ou de la borne 2), les signaux UTI et REF étant tous deux à la fréquence de la porteuse de télé-alimentation. Le circuit 21 comporte, en parallèle, un démodulateur de phase 6 (Δϕ) et un démodulateur d'amplitude 22 (ΔA) . Des bornes d'entrée respectives 23 et 24 du démodulateur de phase 6 et du démodulateur d'amplitude 22 reçoivent le signal à mesurer UTI. Des bornes de référence respectives 25 et 26 des démodulateurs 6 et 22 reçoivent le signal de référence REF. Les constitutions respectives du démodulateur 6 et du démodulateur 22 sont classiques. Un exemple de réalisation sera décrit par la suite en relation avec la figure 7.

Selon l'invention, les sorties respectives 27, 28 des démodulateurs 6 et 22 sont mélangées dans un sommateur 29 dont la sortie 30 fournit un signal image du signal de modulation du transpondeur 10, c'est-à-dire le résultat de la démodulation à destination du circuit 5. De plus, un des démodulateurs est en série avec un retardateur 31 (τ), par exemple, une ligne à retard, pour compenser un éventuel décalage de temps de propagation entre le démodulateur de phase 6 et le démodulateur d'amplitude 22.

De préférence, le retardateur 31 est associé au démodulateur d'amplitude plutôt qu'au démodulateur de phase. On simplifie ainsi la réalisation du démodulateur de phase. En effet, le démodulateur d'amplitude et le démodulateur de phase comprennent tous deux des filtres passe-bas. Toutefois, la réalisation d'un filtre passe-bas pour un démodulateur de phase est souvent plus délicate que pour un démodulateur d'amplitude. Par conséquent, en reportant la ligne à retard côté amplitude, on évite l'introduction d'une perturbation supplémentaire sur la voie de démodulation de phase.

De préférence, le retardateur 31 est réglable et son entrée de réglage est commandée par un régulateur 50 (REG) chargé d'asservir le retard sur une valeur de consigne par rapport au signal de sortie (démodulé) fourni par le sommateur 29. En fait, la valeur de consigne représente un niveau attendu en sortie 30 du sommateur.

La figure 5 illustre la caractéristique tension-fréquence d'un démodulateur d'amplitude. Comme cela a été indiqué précédemment, cette caractéristique présente, comme pour un démodulateur de phase, un trou de fonctionnement du démodulateur d'amplitude (fréquence f'0), c'est-à-dire que la tension V28 (ou V22) de sortie du démodulateur s'annule ou presque à une fréquence f'0 de résonance du circuit L1, C1.

Toutefois, pour un circuit donné, c'est-à-dire pour une fréquence de porteuse donnée et pour un dimensionnement donné des composants des circuits oscillants associés à une mutuelle inductance donnée entre ces circuits, les trous de démodulation sont à des fréquences différentes pour un démodulateur de phase (fréquence f0) et pour un démodulateur d'amplitude (fréquence f'0). Ainsi, en mélangeant les résultats respectifs obtenus par les deux démodulateurs, on obtient une caractéristique tension-fréquence telle qu'illustrée par la figure 6 dans laquelle il n'existe plus de trou de démodulation, c'est-à-dire de fréquence pour laquelle la tension V30 en sortie du circuit 21 s'annule.

La figure 7 représente, sous forme de blocs, un exemple de réalisation préféré d'un circuit de démodulation 21 selon l'invention.

Le démodulateur de phase 23 est, par exemple, basé sur l'emploi d'une porte OU-Exclusif 31 (XOR). La porte 31 reçoit, sur une première entrée 32, le signal de référence REF et, sur une deuxième entrée 33, le signal utile UTI. Les signaux d'entrée sont de même fréquence et mis en forme préalablement aux entrées 32 et 33. En particulier, ces signaux sont déphasés de 90° l'un par rapport à l'autre au repos, c'est-à-dire qu'ils sont soumis à un déphasage de base de 90° en l'absence de modulation de phase. Dans l'exemple représenté à la figure 7, le signal de référence REF est déphasé de 90° dans un déphaseur 34. De plus, les signaux utiles et de référence sont généralement écrêtés dans des écrêteurs respectifs 35 et 36 en amont des entrées 32 et 33. La sortie de la porte 31 fournit un signal de fréquence double par rapport à la fréquence des signaux UTI et REF. Cette sortie attaque un moyenneur 37 formé, par exemple et de façon simplifiée, d'une résistance R et d'un condensateur C. Le moyenneur 37 constitue également un filtre passe-bas et est en série avec un amplificateur 38 pour disposer, en sortie 27, d'une amplitude acceptable.

Le démodulateur d'amplitude 22 est, par exemple, basé sur un multiplieur 41 recevant en entrée les signaux UTI et REF. La sortie du multiplieur 41 est envoyée sur un filtre passe-bas 42 constituant la sortie du démodulateur d'amplitude proprement dit. Cette sortie est envoyée sur l'entrée du dispositif retardateur 31 de l'invention.

Les sorties 27 et 28 des branches parallèles de démodulation de phase et d'amplitude sont sommées dans un sommateur 29 dont la sortie 30 fournit le résultat de la démodulation.

Selon le mode de réalisation préféré représenté, le retardateur 31 est constitué d'un transistor à effet de champ 51 (par exemple, un transistor JFET) et d'un élément capacitif 52. Le transistor 51 relie la sortie du filtre 42 à l'entrée 28 du sommateur 29 (ou à la sortie 28 de la branche de démodulation d'amplitude). Le condensateur 52 relie la borne 28 à la masse. La grille du transistor 51 constitue la borne d'entrée de réglage du retardateur 31. On forme ainsi une cellule résistive et capacitive dont la constante de temps est rendue réglable par une modification de la résistance série du transistor 51 à l'état passant.

Le régulateur 50 est, par exemple, constitué d'un élément de redressement 53 dont l'entrée est reliée en sortie 30 du sommateur 29 et dont la sortie est reliée à une première entrée d'un comparateur 54 (COMP). La deuxième entrée du comparateur 54 reçoit un signal de consigne ENT prédéterminé. Le comparateur 54 fournit un signal (analogique) faisant varier la tension de grille du transistor 51 pour en modifier la résistance série. Le transistor 51 est donc commandé en linéaire. Le rôle du redresseur 53 est de convertir le signal (approximativement sinusoïdal) de sortie du sommateur 30 en un niveau continu représentant sa valeur efficace à comparer au niveau de consigne ENT. Le redresseur est préférentiellement double alternance pour des questions de rapidité.

Le signal de consigne ENT est déterminé empiriquement en fonction des variations de fréquence de fonctionnement attendues pour garantir que le signal de commande du transistor 51 place ce dernier dans une plage de retards correcte.

D'autres constitutions de retardateur pourront être envisagées. Par exemple, on pourra utiliser un réseau de résistances commutable pour modifier le retard.

Un avantage de la présente invention est que le circuit de démodulation 21 ne présente plus de trou de démodulation. Ce résultat est atteint sans qu'il soit nécessaire d'intervenir sur les démodulateurs de phase et d'amplitude. En effet, selon l'invention, la présence d'un trou de démodulation dans le spectre de démodulateur d'amplitude et de phase n'a désormais plus d'importance. Si le système se trouve dans une configuration où l'un des démodulateurs de phase ou d'amplitude fournit un signal trop faible, l'autre démodulateur donnera alors un résultat correct.

Un autre avantage de la présente invention est qu'elle est indépendante du transpondeur. Ainsi, il n'est pas nécessaire de modifier les transpondeurs existants pour qu'ils puissent fonctionner avec une borne de lecture-écriture selon l'invention.

Un autre avantage de l'invention est que, même côté borne de lecture-écriture, les modifications nécessaires par rapport à une borne classique sont limitées. En particulier, l'invention ne requiert aucun changement d'entrée-sortie par rapport à un démodulateur classique. En effet, le circuit 21 de l'invention nécessite, comme un démodulateur de phase classique, une entrée de signal de référence, une entrée de signal utile et une sortie fournissant le résultat de la démodulation. Seule l'entrée de consigne ENT du régulateur doit, selon le mode de réalisation préféré, être ajoutée.

Un autre avantage de l'invention est qu'en régulant le retard, on garantit un niveau optimal en sortie du circuit de démodulation. On optimise donc la portée du système malgré d'éventuelles dérives en fonctionnement de la fréquence du circuit oscillant de la borne.

Bien entendu, la présente invention est susceptible de diverses variantes et modifications qui apparaîtront à l'homme de l'art. En particulier, la réalisation pratique du circuit de démodulation de l'invention est à la portée de l'homme du métier en fonction de l'application et des indications fonctionnelles données ci-dessus. De plus, on notera que d'autres types de démodulateurs de phase et d'amplitude pourront être utilisés pourvu de respecter l'utilisation (au moins fonctionnelle) d'une ligne à retard sur l'une des branches de démodulation en parallèle pour compenser d'éventuelles différences de temps de propagation dans les branches. Par exemple, un démodulateur d'amplitude pourra être basé sur une détection crête. En outre, bien que l'invention ait été décrite ci-dessus en relation avec une mesure du signal dans le circuit oscillant de la borne au moyen d'un transformateur d'intensité, d'autres moyens de mesure pourront être utilisés, par exemple, une mesure de tension aux bornes du condensateur C1.

Enfin, bien que l'invention ait été décrite ci-dessus en relation avec un mode de réalisation supposant une réalisation analogique des éléments, celle-ci pourra être mise en oeuvre par des moyens numériques, par exemple, au moyen d'un processeur de signal numérique (DSP), voire de façon logicielle.

Parmi les applications de la présente invention, on signalera plus particulièrement les lecteurs (par exemple, les bornes ou portiques de contrôle d'accès, les distributeurs automatiques de produits, les terminaux d'ordinateurs, les terminaux téléphoniques, les téléviseurs ou décodeurs satellites, etc.) de cartes à puce sans contact (par exemple les cartes d'identification pour contrôle d'accès, les cartes porte-monnaie électroniques, les cartes de stockage d'informations sur le possesseur de la carte, les cartes de fidélité de consommateurs, les cartes de télévision à péage, etc.).

## Revendications

**1.** Circuit de démodulation d'un signal émis par un transpondeur électromagnétique, comprenant un capteur (7) d'une grandeur fonction de la charge constituée par le transpondeur sur un circuit oscillant (L1, C1), et un démodulateur de phase (6) et un démodulateur d'amplitude (22) au moins fonctionnellement en parallèle et recevant un signal issu dudit capteur, **caractérisé en ce qu'**il comporte :

un sommateur (29) des résultats fournis par lesdits démodulateurs ; et
un retardateur (31) en série avec un premier desdits démodulateurs, pour compenser une éventuelle différence de temps de propagation entre eux.

**2.** Circuit selon la revendication 1, **caractérisé en ce qu'**il comporte en outre un régulateur (50) du retard apporté par ledit retardateur (31) en fonction du signal fourni par ledit sommateur (29).

**3.** Circuit selon la revendication 2, **caractérisé en ce que** ledit régulateur (50) comporte :

un élément de redressement (53) dont l'entrée est reliée à la sortie du sommateur (29) ;
un comparateur (54) dont une première entrée reçoit le signal fourni par ledit élément de redressement et dont une deuxième entrée reçoit un signal de consigne (ENT), la sortie du comparateur commandant ledit élément retardateur (31).

**4.** Circuit selon la revendication 2 ou 3, **caractérisé en ce que** lesdits démodulateurs (6, 22), sommateur (29), retardateur (31) et régulateur (50) sont réalisés sous la forme d'un processeur numérique de traitement de signal.

**5.** Circuit selon l'une quelconque des revendications 1 à 4, **caractérisé en ce que** ledit premier démodulateur auquel est associé le retardateur (31) est le démodulateur d'amplitude (22) .

**6.** Circuit selon l'une quelconque des revendications 1 à 5, **caractérisé en ce que** ledit retardateur (31) est constituée d'un élément résistif commandable (51) en série avec ledit premier démodulateur (22), et d'un élément capacitif (52) reliant une borne de l'élément résistif à un potentiel de référence.

**7.** Circuit selon la revendication 6, **caractérisé en ce que** ledit élément résistif (51) est constitué d'un transistor à effet de champ dont une grille reçoit un signal de régulation fourni par ledit régulateur (50) et qui conditionne sa résistance série.

**8.** Circuit selon l'une quelconque des revendications 1 à 7, **caractérisé en ce que** ledit capteur (7) mesure le courant (I) dans le circuit oscillant (L1, C1), ou la tension aux bornes d'un ou plusieurs de ses éléments.

**9.** Borne (20) de génération d'un champ électromagnétique propre à communiquer avec au moins un transpondeur (10) lorsque ce dernier entre dans ce champ, **caractérisée en ce qu'**elle comporte un circuit de démodulation (21) selon l'une quelconque des revendications 1 à 8.

**10.** Procédé de démodulation d'un signal émis par un transpondeur électromagnétique **caractérisé en ce qu'**il consiste :

à mesurer une grandeur fonction de la charge constituée par le transpondeur sur un circuit oscillant (L1, C1) ;
à démoduler en phase le signal mesuré ;
à démoduler en amplitude le signal mesuré ;
à retarder un premier résultat d'au moins une des démodulation par rapport à l'autre ;
à sommer les résultats des deux démodulations ; et
à réguler le retard apporté audit premier résultat de démodulation en fonction du résultat de la sommation.

**11.** Procédé selon la revendication 10, **caractérisé en ce qu'**il est mis en oeuvre par des moyens de traitement numérique.

**12.** Procédé selon la revendication 10, **caractérisé en ce qu'**il est mis en oeuvre par des circuits analogiques.

**Claims**

**1.** A circuit for demodulating a signal transmitted by an electromagnetic transponder, comprising a sensor (7) of a variable which is a function of the load formed by the transponder on an oscillating circuit (L1, C1) and a phase demodulator (6) and an amplitude demodulator (22) at least functionally in parallel and receiving a signal coming from said sensor, **characterized in that** it comprises:

a summer (29) of the results provided by said demodulators; and
a delay element (31) in series with a first one of said demodulators, to compensate for a possible propagation time difference therebetween.

**2.** The circuit of claim 1, **characterized in that** it comprises a regulator (50) of the delay introduced by said delay element (31) according to the signal provided by said summer (29).

**3.** The circuit of claim 2, **characterized in that** said regulator (50) comprises:

a rectifying element (53) having its input connected to the summer output (29) ;
a comparator (54) having a first input receiving the signal provided by said filter and having a second input receiving a reference signal (ENT), the comparator output controlling said delay element (31).

**4.** The circuit of claim 2 or 3, **characterized in that** said demodulators (6, 22), summer (29), delay element (31), and regulator (50) are made in the form of a digital signal processor.

**5.** The circuit of any of claims 1 to 4, **characterized in that** said first demodulator to which the delay element (31) is associated is the amplitude demodulator (22).

**6.** The circuit of any of claims 1 to 5, wherein said delay element (31) is formed of a controllable resistive element (51) in series with said first demodulator (22), and of a capacitive element (52) connecting a terminal of the resistive element to a reference voltage.

**7.** The circuit of claim 6, **characterized in that** said resistive element (51) is formed of a field-effect transistor, a gate of which receives a regulation signal provided by said regulator (50) and which conditions its series resistance.

**8.** The circuit of any of claims 1 to 7, **characterized in that** said sensor (7) measures the current (I) in the oscillating circuit (L1, C1), or the voltage across one or several of its elements.

**9.** A terminal (20) of generation of an electromagnetic field capable of communicating with at least one transponder (10) when said transponder enters this field, **characterized in that** it comprises the demodulation circuit (21) of any of claims 1 to 8.

**10.** A method for demodulating a signal transmitted by an electromagnetic transponder **characterized in that** it consists of:

measuring a variable which is a function of the load formed by the transponder on an oscillating circuit (L1, C1);
demodulating in phase the measured signal;
demodulating in amplitude the measured signal;
delaying a first result of at least one of the demodulations with respect to the other;
summing up the results of the two demodulations; and
regulating the delay brought to said first demodulation result according to the result of the sum integration.

**11.** The method of claim 10, implemented by digital processing means.

**12.** The method of claim 10, implemented by analog circuits.

**Patentansprüche**

**1.** Schaltung zum Demodulieren eines von einem elektromagnetischen Transponder ausgesandten Signals, mit einem Meßwertfühler bzw -aufnehmer (7) für eine Größe, die eine Funktion der Last ist, welche der Transponder für einen Schwingkreis (L1,C1) bildet, sowie mit einem Phasendemodulator (6) und einem Amplitudendemodulator (22), die wenigstens funktionell parallel geschaltet sind und ein von dem genannten Meßwertfühler bzw -aufnehmer ausgehendes Signal zugeführt erhalten, **dadurch gekennzeichnet daß** die Schaltung umfaßt :

> eine Summationsvorrichtung (29) zur Addition der von den Demodulatoren gelieferten Resultate;
> eine Verzögerungsvorrichtung (31) in Reihe mit einem ersten der genannten Demodulatoren, zur Kompensation einer eventuellen Laufzeit-differenz zwischen ihnen

**2.** Schaltung nach Anspruch 1, **dadurch gekennzeichnet, daß** sie des weiteren einen Regler (50) für die Verzögerung aufweist, die von der Verzögerungsvorrichtung (31) in Abhängigkeit von dem durch die Summationsvorrichtung (29) gelieferten Signal eingeführt wird

**3.** Schaltung nach Anspruch 2, **dadurch gekennzeichnet, daß** der Regler (50) umfasst:

> ein Gleichrichtelement (53), dessen Eingang mit dem Ausgang der Summationsvorrichtung (29) verbunden ist;
> einen Komparator (54), der an einem ersten Eingang das von dem Gleichrichtelement gelieferte Signal und an einem zweiten Eingang ein Vorgabe- bzw. Einstellsignal (ENT) zugeführt erhält, wobei der Ausgang des Komparators das genannte Verzögerungselement (31) steuert.

**4.** Schaltung nach Anspruch 2 oder 3, **dadurch gekennzeichnet, daß** die Demodulatoren (6, 22), die Summationsvorrichtung (29), die Verzögerungsvorrichtung (31) und der Regler (50) in Form eines digitalen Signalverarbeitungsprozessors ausgebildet sind.

**5.** Schaltung nach einem der Ansprüche 1 bis 4, **dadurch gekennzeichnet, daß** der genannte erste Demodulator, dem die Verzögerungsvorrichtung (31) zugeordnet ist, der Amplitudendemodulator (22) ist.

**6.** Schaltung nach einem der Absprüche 1 bis 5, **dadurch gekennzeichnet, daß** die Veizögerungsvorrichtung (31) aus einem steuerbaren Widerstandselement (51) in Reihe mit dem ersten Demodulator (22) und aus einem kapazitiven Element (52) besteht, das einen Anschluß des Widerstandselements mit einem Bezugspotential verbindet.

**7.** Schaltung nach Anspruch 6, **dadurch gekennzeichnet, daß** das Widerstandselement (51) von einem Feldeffekttransistor gebildet wird, dem an einem Gateanschluß ein von dem Regler (50) geliefertes Regelsignal zugeführt wird, das seinen Reihenwiderstand konditioniert.

**8.** Schaltung nach einem der Ansprüche 1 bis 7, **dadurch gekennzeichnet daß** der Meßwertfühler bzw. -aufnehmer (7) den Strom (I) in dem Schwingkreis (L1, C1) oder die Spannung an den Anschlüssen eines oder mehrerer seiner Elemente mißt.

**9.** Terminal (20) zur Erzeugung eines elektromagnetischen Feldes, das mit wenigstens einem Transponder (10) bei dessen Eintritt in das Feld zu kommunizieren vermag, **dadurch gekennzeichnet, daß** das Terminal eine Demodulationsschaltung (21) gemäß einem der Ansprüche 1 bis 8 aufweist.

**10.** Verfahren zur Demodulation eines von einem elektromagnetischen Transponder ausgesandten Signals, **dadurch gekennzeichnet**, das das Verfahren umfasst:

> Messen einer Größe, die eine Funktion der Last ist, welche von dem Transponder für einen Schwingkreis (L1, C1) gebildet wird;
> Phasendemodulation des gemessenen Signals;
> Amplitudendemodulation des gemessenen Signals;
> Verzögern des ersten Resultats wenigstens einer der Demodulationen;
> Summation der Resultate der beiden Demodulationen; sowie
> Regeln der auf das erste Demodulationsresultat ausgeübten Verzögerung, in Abhängigkeit vom Resultat der Summation

**11.** Verfahren nach Anspruch 10, **dadurch gekennzeichnet, daß** es vermittels digitaler Verarbeitungsmittel ausgeführt wird

**12.** Verfahren nach Anspruch 10, **dadurch gekennzeichnet, daß** es vermittels analoger Schaltungen

ausgeführt wird

Fig 1

Fig 2

Fig 3

**Fig 4**

**Fig 5**

**Fig 6**

**Fig 7**